(19) Europäisches Patentamt
European Patent Office
Office européen des brevets

(11) **EP 4 036 950 B1**

(12) **FASCICULE DE BREVET EUROPEEN**

(45) Date de publication et mention
de la délivrance du brevet:
**12.07.2023 Bulletin 2023/28**

(21) Numéro de dépôt: **22153732.7**

(22) Date de dépôt: **27.01.2022**

(51) Classification Internationale des Brevets (IPC):
***H01H 47/32*** *(2006.01)*     ***H01H 47/36*** *(2006.01)*
***H01F 7/18*** *(2006.01)*

(52) Classification Coopérative des Brevets (CPC):
**H01H 47/325; H01F 7/1844; H01H 47/36;**
H01F 2007/1866

(54) **ACTIONNEUR ÉLECTROMAGNÉTIQUE ET PROCÉDÉ DE COMMANDE D'UN ACTIONNEUR ÉLECTROMAGNÉTIQUE**

ELEKTROMAGNETISCHER AKTUATOR UND VERFAHREN ZUR STEUERUNG EINES ELEKTROMAGNETISCHEN AKTUATORS

ELECTROMAGNETIC ACTUATOR AND METHOD OF CONTROLLING AN ELECTROMAGNETIC ACTUATOR

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **27.01.2021 FR 2100759**

(43) Date de publication de la demande:
**03.08.2022 Bulletin 2022/31**

(73) Titulaire: **Schneider Electric Industries SAS**
**92500 Rueil-Malmaison (FR)**

(72) Inventeur: **LANES, David**
**38660 SAINT HILAIRE DU TOUVET (FR)**

(74) Mandataire: **Lavoix**
**62, rue de Bonnel**
**69448 Lyon Cedex 03 (FR)**

(56) Documents cités:
EP-A1- 3 185 272     DE-A1- 3 530 966
US-A1- 2003 160 517

**Description**

La présente invention concerne un actionneur électromagnétique et un procédé de commande d'un actionneur électromagnétique.

De façon connue, de nombreux appareils de commutation électrique, tels que des contacteurs, comportent un actionneur électromagnétique permettant de déplacer des contacts électriques mobiles entre une position ouverte et une position fermée. Un tel appareil de commutation électrique est par exemple décrit dans le document EP 3 185 272 A1.

Généralement, l'actionneur électromagnétique comporte une bobine configurée pour générer un champ magnétique lorsqu'elle est excitée par un circuit d'alimentation électrique. Un tel circuit d'alimentation électrique comporte généralement une alimentation à découpage comportant un ou plusieurs transistors pilotés pour exciter la bobine avec un signal d'excitation comprenant une succession d'impulsions de courant.

De tels actionneurs électromagnétiques doivent généralement répondre à des exigences contradictoires en ce qui concerne, d'une part, la consommation d'énergie et, d'autre part, le coût de fabrication, qui doivent tous deux rester limités.

Toutefois, en pratique, il est difficile de construire des actionneurs qui répondent à la fois à ces deux exigences.

Par exemple, des solutions comportant une bobine associée à un transformateur de type flyback permettent d'obtenir une consommation d'électricité faible (par exemple inférieure à 2,3 A), mais cela se fait au détriment du coût de fabrication, qui demeure élevé.

Au contraire, des solutions comportant deux bobines distinctes sont peu coûteuses à fabriquer, mais la consommation du système s'en trouve alors considérablement augmentée, et peut être supérieure à plus de deux fois la consommation de la solution à une bobine.

C'est à ces inconvénients qu'entend plus particulièrement remédier l'invention en proposant un actionneur électromagnétique présentant à la fois une faible consommation d'énergie et un coût de fabrication modéré.

A cet effet, un aspect de l'invention concerne le procédé de pilotage d'un actionneur électromagnétique, comportant une bobine, un circuit d'alimentation électrique pour alimenter la bobine, et un circuit de commande électronique, le circuit d'alimentation comportant un étage de commutation comprenant un pont en H comprenant plusieurs interrupteurs connectés à la bobine,

le premier interrupteur étant connecté dans un premier bras du pont entre une masse électrique du circuit d'alimentation et la bobine, le deuxième interrupteur étant connecté entre le bus de tension et la bobine dans un deuxième bras du pont en H, le troisième interrupteur étant connecté entre la bobine et la masse électrique dans un troisième bras du pont,
le procédé de pilotage comportant des étapes comprenant :

- appliquer une première stratégie de pilotage dans laquelle les premier et troisième interrupteurs sont maintenus dans un état fermé, tandis que le deuxième interrupteur est commuté entre ses états ouvert et fermé ;
- détecter un évènement de surconsommation de courant dans la bobine, en détectant que la tension mesurée sur le bus de commande excède une limite de tension prédéfinie ou en détectant que le rapport cyclique du deuxième interrupteur devient inférieur à une valeur seuil;
- en réponse, appliquer une deuxième stratégie de pilotage, à la place de la première stratégie de pilotage, dans laquelle le troisième interrupteur est périodiquement ouvert afin de diminuer le courant alimentant la bobine.

Grâce à l'invention, lorsque la tension du bus continu dépasse un seuil prédéterminé, une stratégie de pilotage spécifique est mise en place afin de faire baisser le courant bobine jusqu'à revenir en dessous de la limite, tout en continuant à piloter la bobine de manière à assurer un fonctionnement normal de l'actionneur.

Selon des aspects avantageux mais non obligatoires, un tel actionneur électromagnétique peut incorporer une ou plusieurs des caractéristiques suivantes, prises isolément ou suivant toute combinaison techniquement admissible :

- Lorsque la deuxième stratégie de pilotage est appliquée, la tension mesurée est à nouveau comparée avec la valeur de la limite de tension, pour détecter si la tension mesurée est repassée ou non sous la limite de tension, afin de pouvoir, le cas échéant, arrêter la deuxième stratégie de pilotage et appliquer à nouveau la première stratégie de pilotage.
- Dans la deuxième stratégie de pilotage, le rapport cyclique du signal de commande du deuxième interrupteur est donné par la formule suivante :

$$aSW2 = ToffSW3 \text{ x } (Vdc - Vd) + T(Vd\text{-}Ri)/(Tx(Vdc+Vd))$$

où ToffSW3 est le temps pendant lequel le troisième interrupteur (SW3) reste ouvert pendant chaque période, Ri est égal au produit du courant circulant dans la bobine Bob par la résistance intrinsèque de la bobine, Vd désigne la tension aux bornes d'une diode connectée entre un deuxième point du circuit et la première ligne conductrice du bus de tension, et T est la périodicité du signal de commande du deuxième interrupteur.

- Dans la deuxième stratégie de pilotage, le rapport cyclique du signal de commande du troisième interrupteur reste constant, ou peut varier au cours du temps.
- Les interrupteurs sont des transistors.
- Le courant circulant dans la bobine est mesurée au moyen d'un dispositif de mesure, de préférence associé au troisième transistor.

Selon un autre aspect, l'invention concerne un actionneur électromagnétique, comportant une bobine, un circuit d'alimentation électrique pour alimenter la bobine, et un circuit de commande électronique, le circuit d'alimentation comportant un étage de commutation comprenant un pont en H comprenant plusieurs interrupteurs connectés à la bobine, le premier interrupteur étant connecté dans un premier bras du pont entre une masse électrique du circuit d'alimentation et la bobine, le deuxième interrupteur étant connecté entre le bus de tension et la bobine dans un deuxième bras du pont en H, le troisième interrupteur étant connecté entre la bobine et la masse électrique dans un troisième bras du pont, le circuit de commande électronique étant programmé pour mettre en oeuvre des étapes comportant :

- appliquer une première stratégie de pilotage dans laquelle les premier et troisième interrupteurs sont maintenus dans un état fermé, tandis que le deuxième interrupteur est commuté entre ses états ouvert et fermé ;
- détecter un évènement de surconsommation de courant dans la bobine, en détectant que la tension mesurée sur le bus de commande excède une limite de tension prédéfinie ou en détectant que le rapport cyclique du deuxième interrupteur devient inférieur à une valeur seuil;
- en réponse, appliquer une deuxième stratégie de pilotage, à la place de la première stratégie de pilotage, dans laquelle le troisième interrupteur est périodiquement ouvert afin de diminuer le courant alimentant la bobine.

L'invention sera mieux comprise et d'autres avantages de celle-ci apparaîtront plus clairement à la lumière de la description qui va suivre d'un mode de réalisation d'un actionneur électromagnétique donnée uniquement à titre d'exemple et faite en référence aux dessins annexés, dans lesquels :

[Fig 1] la figure 1 représente schématiquement un appareil de commutation électrique comportant un actionneur électromagnétique conforme à l'invention ;
[Fig 2] la figure 2 représente schématiquement un circuit d'alimentation électrique de l'actionneur électromagnétique de la figure 1 ;
[Fig 3] la figure 3 représente schématiquement l'évolution du courant bobine, du rapport cyclique d'un interrupteur du circuit d'alimentation électrique et de signaux de commande au cours du temps dans le circuit d'alimentation électrique de la figure 2, en fonction de différentes stratégies de pilotage ;
[Fig 4] la figure 4 est un diagramme schématique d'un procédé de pilotage de l'actionneur électromagnétique de la figure 1.

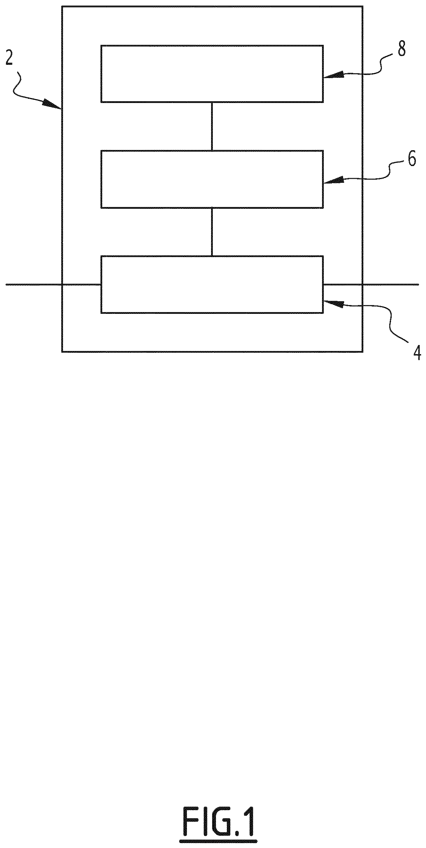

La figure 1 représente schématiquement un appareil de commutation électrique 2 tel qu'un contacteur, ou un relais, ou un disjoncteur, ou tout appareil équivalent.
L'appareil 2 comporte ici des contacts électriques mobiles 4 qui permettent, selon qu'ils sont en position ouverte ou fermée, de bloquer la circulation du courant électrique entre des terminaux de l'appareil 2 ou, au contraire, d'autoriser la circulation de ce courant.
Selon des exemples, l'appareil 2 peut être un appareil multipolaire, ou un appareil unipolaire, et comporte ainsi autant de paires de terminaux que de phases.
L'appareil 2 comporte également un actionneur électromagnétique comportant une bobine, un circuit d'alimentation électrique 6 configuré pour alimenter la bobine et un circuit électronique de commande 8. Dans ce qui suit, on pourra désigner l'actionneur par la référence « 6 ».
L'actionneur 6 est couplé aux contacts mobiles 4, par exemple par un couplage mécanique ou électromagnétique et permet de déplacer, directement ou indirectement, les contacts mobiles 4 selon que la bobine est alimentée ou non.
Le circuit électronique de commande 8 configuré pour piloter le fonctionnement de l'actionneur, comme on le verra ci-après.
Par exemple, le circuit électronique de commande 8 comporte un processeur, tel qu'un microcontrôleur programmable ou un microprocesseur.
Le processeur est par exemple couplé à une mémoire informatique, ou à tout support d'enregistrement de données lisible par ordinateur, qui comporte des instructions exécutables et/ou un code logiciel prévu pour mettre en oeuvre un procédé de pilotage tel que celui décrit ci-après.

Selon des variantes, le circuit électronique de commande 8 peut comporter d'autres éléments, tel qu'un processeur de traitement du signal (DSP), ou un composant logique reprogrammable (FPGA), ou un circuit intégré spécialisé (ASIC), ou tout élément équivalent.

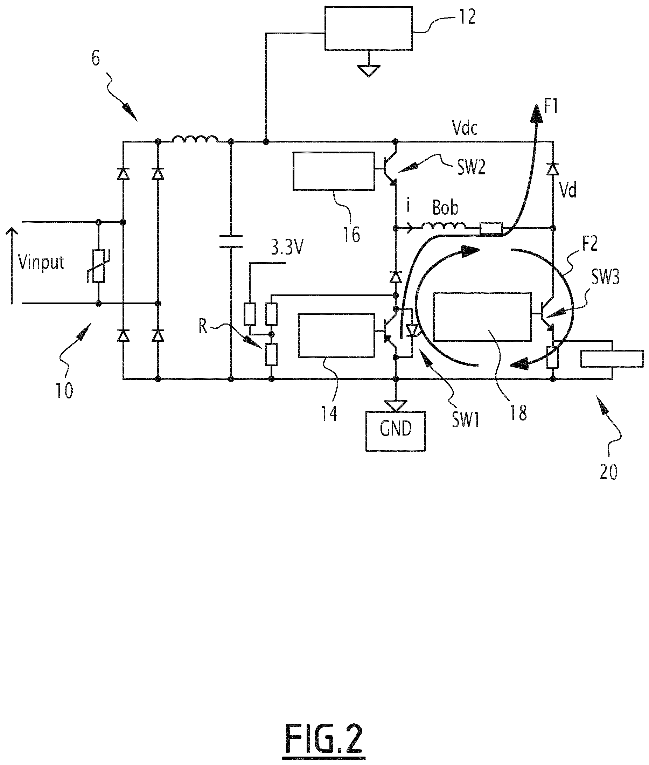

La figure 2 représente un exemple de réalisation de l'actionneur 6.

L'actionneur 6 comporte une bobine « Bob » et un circuit d'alimentation électrique configuré pour fournir un courant électrique d'excitation (courant bobine) à la bobine afin d'exciter cette dernière, par exemple pour générer un champ magnétique permettant d'agir sur la position des contacts mobiles 4.

Par exemple, le circuit d'alimentation électrique comporte un étage d'entrée 10 qui reçoit une tension électrique d'entrée Vinput, par exemple délivrée entre des bornes d'entrée par une source d'électricité.

L'étage d'entrée 10 peut comporter un redresseur, tel qu'un pont de diodes, ainsi que des moyens de protection contre des surtensions ou des surintensités. L'étage d'entrée 10 peut aussi comporter des moyens de filtrage, tel qu'un condensateur de filtrage.

Le circuit d'alimentation comporte également, en aval de l'étage d'entrée, un bus de tension continue Vdc comprenant une première ligne conductrice et une deuxième ligne conductrice connectée à une masse électrique GND du circuit. Un régulateur linéaire de tension 12 est ici connecté à la première ligne du bus de tension.

Le circuit d'alimentation comporte également un étage de commutation comprenant un pont en H comprenant plusieurs interrupteurs connectés à la bobine Bob.

Par exemple, la bobine Bob est connectée entre un premier point et un deuxième point, qui forment les points médians du pont en H. One note ici « i » le courant d'excitation qui circule dans la bobine. La bobine Bob est configurée pour être couplée avec un élément mobile de l'actionneur, tel qu'une palette mobile, par exemple pour déplacer les contacts mobiles 4. La bobine Bob comporte une résistance interne liée à sa construction et qui illustrée comme une résistance R connectée en série entre un premier point et un deuxième point.

De préférence, une seule bobine est connectée entre le premier point et le deuxième point dans le pont en H. Autrement dit, il n'y a pas de deuxième bobine connectée en série avec la bobine Bob et étant couplée avec un élément mobile de l'actionneur 6.

Par exemple, l'étage de commutation comporte trois interrupteurs de puissance SW1, SW2 et SW3, ici chacun associé à une branche du pont en H.

Un premier interrupteur SW1 est connecté entre la masse GND et le premier point, formant un premier bras du pont en H.

L'interrupteur SW1 (« fast falling switch » en anglais) est ici connecté en parallèle avec une diode d'écrêtage de roue libre, et en série avec une autre diode placée entre l'interrupteur SW1 et le premier point.

Un deuxième interrupteur SW2 (« high side switch ») est connecté entre le premier point du pont en H et la première ligne du bus de tension Vdc.

Un troisième interrupteur SW3 (« low side switch ») est connecté entre le deuxième point du pont en H et la masse électrique.

Par exemple, les interrupteurs sont des transistors, de préférence des transistors conventionnels, tels que des transistors de puissance, ou des transistors MOSFET, ou tout transistor approprié.

Par exemple, le quatrième bras du pont en H peut comporter une diode connectée entre le deuxième point et la première ligne conductrice. On note Vd la tension aux bornes de cette diode.

Les interrupteurs SW1, SW2 et SW3, et notamment les interrupteurs SW2 et SW3, sont pilotés par le circuit de commande 8, par exemple pour alimenter la bobine avec des impulsions de courant électrique, afin de placer la bobine dans un état excité (inrush) et/ou maintenir la bobine dans un état excité.

Par exemple, dans chaque interrupteur, une électrode de commande est configurée pour recevoir un signal de commande émis par le circuit de commande 8.

Optionnellement, dans certains modes de réalisation, le circuit 6 peut comporter un module de diagnostic connecté en parallèle du transistor SW1, ce module étant configuré pour mesurer une tension représentative du courant qui circule au travers du transistor SW1, par exemple au moyen d'un pont de résistances R. Ce module de diagnostic peut cependant être omis.

Sur le schéma de la figure 2, les blocs 14, 16 et 18 représentent, de façon simplifiée, les modules de commande, ou drivers, qui pilotent respectivement les transistors SW1, SW2 et SW3. On comprend que ces modules de commande 14, 16 et 18 peuvent faire partie du circuit de commande 8.

Le circuit d'alimentation comporte également un dispositif de mesure 20, ici associé au transistor SW3, qui est configuré pour mesurer le courant qui circule au travers du transistor SW3, par exemple au moyen d'une résistance de mesure connectée en série avec le transistor SW3, ce qui permet de mesurer l'image du courant circulant dans la bobine Bob. Ce dispositif 20 permet in fine de réguler le courant dans la bobine.

Conformément à l'invention, le circuit de contrôle 8 est programmé pour piloter les transistors de manière à réguler le courant d'excitation de la bobine, notamment en maintenant le courant d'excitation de la bobine sous une limite prédéfinie, afin de réduire la consommation d'énergie de l'actionneur.

Cette stratégie peut être mise en oeuvre dès que survient un évènement susceptible de représenter une surconsommation de courant dans la bobine Bob (« évènement de surconsommation »), par exemple lorsque la tension du bus continu Vdc devient supérieure à une valeur limite Vlim, ou, de façon équivalente, lorsque le rapport cyclique de la commande de l'interrupteur SW2 (rapport de la durée de fermeture pendant une période sur la durée totale d'une période, étant entendu que l'interrupteur SW2 est ouvert et fermé périodiquement) passe sous une valeur seuil prédéfinie notée DC_lim.

En d'autres termes, le circuit de commande 8 est configuré pour mettre en oeuvre plusieurs stratégies de pilotage (ou de commande) différentes.

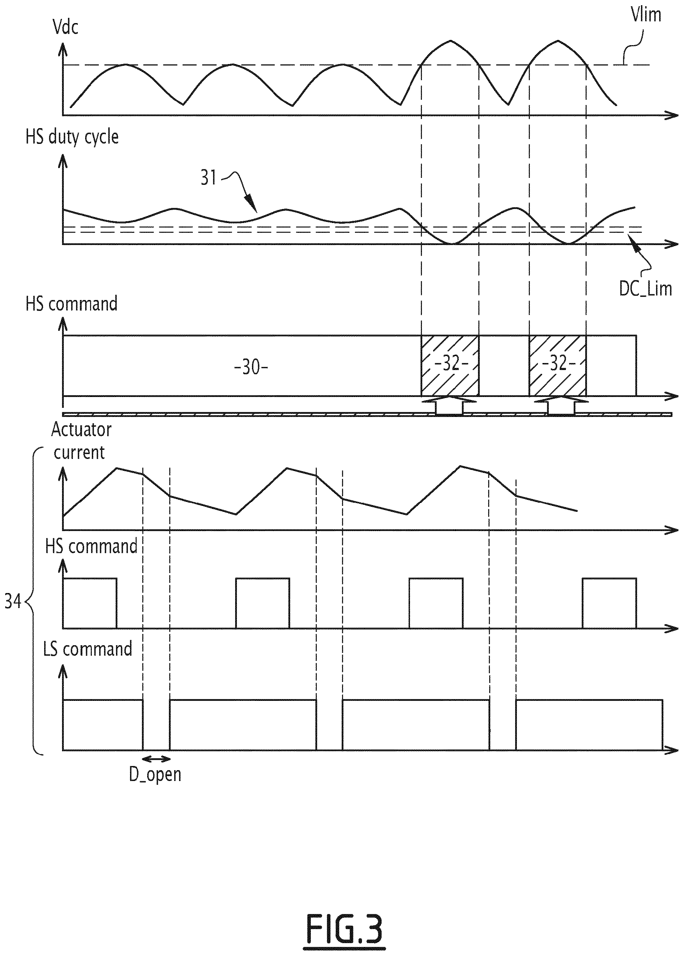

La figure 3 illustre un exemple de fonctionnement de l'actionneur 6.

Le graphe Vdc illustre un exemple de l'évolution de la tension électrique du bus de tension Vdc au cours du temps (axe des abscisses). La ligne en traits pointillés correspond à la valeur du seuil de tension Vlim.

Le graphe HS_duty_cycle illustre l'évolution du rapport cyclique de l'interrupteur SW2 au cours du temps (axe des abscisses). La ligne en double traits pointillés correspond à la valeur seuil DC_lim.

Le graphe command_strategy illustre la stratégie de pilotage mise en place au cours du temps (axe des abscisses) par le circuit de commande 8 en fonction de la valeur de la tension Vdc.

Par exemple, une première stratégie de pilotage 30 (stratégie normale) est mise en place tant que la tension électrique Vdc reste inférieure à la limite Vlim.

De préférence, dans la première stratégie de pilotage, l'interrupteur SW1 et l'interrupteur SW3 sont maintenus fermés (i.e., dans un état passant), pour permettre le passage du courant, alors que l'interrupteur SW2 est commuté alternativement entre ses états ouvert et fermé, avec une fréquence de commutation prédéfinie.

Par exemple, le rapport cyclique du signal de commande de l'interrupteur SW2 (défini comme le rapport, pour chaque période, entre la durée pendant laquelle l'interrupteur est fermé sur la durée totale de la période) peut varier en fonction de conditions de fonctionnement du circuit d'alimentation.

En pratique, la durée pendant laquelle l'interrupteur SW2 reste fermé pendant chaque période est inférieur au temps nécessaire pour commuter l'interrupteur SW2.

Selon un exemple avantageux, le rapport cyclique aSW2 du signal de commande de l'interrupteur SW2 est donné par la formule suivante :

$$a\,W2 = ToffSW3 \times (Vdc - Vd) + T(Vd\text{-}Ri)/(Tx(Vdc+Vd))$$

où ToffSW3 est le temps pendant lequel l'interrupteur SW3 reste ouvert pendant chaque période, Ri est égal au produit du courant circulant dans la bobine Bob par la valeur de la résistance interne R de bobine Bob, et T est la périodicité du signal de commande de l'interrupteur SW2.

Une deuxième stratégie de pilotage 32 est mise en place lorsque la tension électrique Vdc dépasse la limite Vlim, et cette stratégie reste imposée jusqu'à ce que la tension électrique Vdc devienne inférieure à la limite Vlim. De façon équivalente, cette condition peut correspondre au passage du rapport cyclique de l'interrupteur SW2 sous la valeur seuil DC_lim.

La portion 34 de la figure 3 représente plus en détail l'évolution du temps (axe des abscisses) du courant bobine (Actuator current), du signal de commande du transistor SW2 (HS command) et du signal de commande du transistor SW3 (LS command), lorsque la deuxième stratégie de pilotage 32 est appliquée par le circuit de commande 8.

Dans cette deuxième stratégie de pilotage, l'interrupteur SW1 est maintenu fermé, tandis que l'interrupteur SW2 continue à être commuté alternativement entre ses états ouvert et fermé, avec la même fréquence de commutation prédéfinie. Mais, cette fois, l'interrupteur SW3 est périodiquement ouvert afin de diminuer le courant bobine.

Avantageusement, l'ouverture de l'interrupteur SW3 est synchronisée avec l'ouverture de l'interrupteur SW2 pour que l'interrupteur SW3 soit ouvert en même temps que l'interrupteur SW2.

Ouvrir temporairement l'interrupteur SW3 permet d'augmenter le taux de variation du courant bobine (i.e., la dérivée du courant en fonction du temps), et donc d'accélérer sa diminution, de préférence jusqu'à atteindre une valeur plus faible, permettant de diminuer la consommation électrique de l'actionneur. Par exemple, lorsque l'interrupteur SW3 est ouvert, le courant de roue libre circule au travers de la bobine entre la masse et la ligne Vdc en suivant la trajectoire représentée par la flèche F1 sur la figure 2, par exemple en passant par la branche du pont en H comportant l'interrupteur SW1, puis la bobine, puis la diode Vd.

Une fois l'interrupteur SW3 à nouveau fermé, le taux de variation du courant bobine diminue, ce qui signifie que le courant bobine se stabilise, de préférence à une valeur de courant éloignée de son maximum.

Par exemple, lorsque l'interrupteur SW3 est fermé, le courant de roue libre circule au travers de la bobine et la masse en suivant la trajectoire représentée par la flèche F2 sur la figure 2, par exemple en circulant dans la maille de circuit formée par la branche du pont en H comportant l'interrupteur SW1, puis la bobine, puis la branche du pont en H comportant l'interrupteur SW3.

Sur la figure 3, on note « D_open » la durée d'ouverture de l'interrupteur SW3. Par exemple, le rapport cyclique du signal de commande de l'interrupteur SW3 reste constant. En variante, le rapport cyclique du signal de commande de l'interrupteur SW3 pourrait être variable.

A titre d'exemple, une durée d'ouverture de 2μs correspond à un rapport cyclique de 96% pour une fréquence de commutation de 20 kHz.

Ainsi, le courant d'excitation de la bobine est régulé de sorte à limiter le courant traversant la bobine quelle que soit la tension d'entrée. Grâce à l'invention, lorsque la tension du bus continu dépasse un seuil prédéterminé, une stratégie de pilotage spécifique est mise en place afin de faire baisser le courant bobine jusqu'à revenir en dessous de la limite, tout en continuant à piloter la bobine de manière à assurer un fonctionnement normal de l'actionneur.

En particulier, en utilisant cette architecture couplée à la stratégie de pilotage hybride, il est possible de n'utiliser qu'une seule bobine sans avoir besoin d'utiliser un transformateur flyback dans le circuit d'alimentation, et d'obtenir quand même une consommation d'énergie réduite par rapport aux solutions connues utilisant deux bobines.

Par exemple, le courant de démarrage (inrush current) est ici inférieur ou égal à 2,5 A.

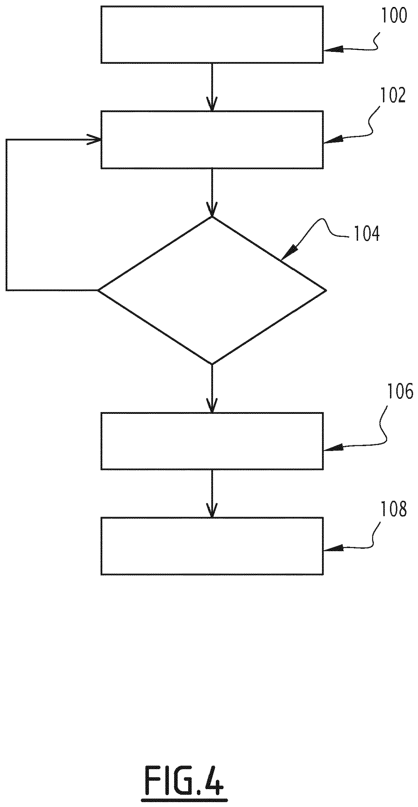

Un exemple d'un procédé de pilotage est maintenant décrit en référence à la figure 4.

Le procédé démarre à l'étape 100, par exemple suite à la réception d'un ordre de commande pour exciter la bobine de l'actionneur 6.

Lors d'une étape 102, le circuit de commande 8 applique la première stratégie de commande pour piloter les interrupteurs SW1, SW2 et SW3.

En parallèle, lors d'une étape 104, le circuit de commande 8 identifie le rapport cyclique de l'interrupteur SW2 et applique la deuxième stratégie de commande lorsque la valeur du rapport cyclique devient inférieure à la valeur seuil DC_lim prédéfinie.

Cette identification peut être réalisée à partir du signal de commande fourni par le circuit de commande 8 à l'interrupteur, ou bien par d'autres moyens, par exemple en mesurant la tension Vdc.

Alternativement, la détection peut être réalisée de façon indirecte, par exemple en comparant la tension Vdc mesurée avec la valeur de la limite de tension Vlim, puisque l'évolution de la tension Vdc est liée à l'évolution du rapport cyclique de l'interrupteur SW2. Par exemple, la tension Vdc est mesurée au moyen du dispositif de mesure 20.

Si la tension mesurée Vdc est détectée comme excédant la limite de tension Vlim, ou de façon équivalente si le rapport cyclique de l'interrupteur SW2 est détecté comme devenant inférieur à la valeur seuil DC_lim, alors, lors d'une étape 106, la deuxième stratégie de régulation précédemment décrite est mise en oeuvre à la place de la première stratégie de pilotage. Dans le cas où la tension mesurée Vdc n'excède pas la limite de tension Vlim, ou lorque le rapport cyclique de l'interrupteur SW2 reste supérieur à la valeur seuil DC_lim, alors la première stratégie de commande reste en place.

Ensuite, à l'étape 106, le circuit de commande 8 continue de comparer la tension Vdc mesurée avec la valeur de la limite de tension Vlim, pour détecter si la tension mesurée Vdc est repassée ou non sous la limite de tension Vlim, ou de façon équivalente de comparer la valeur déterminée du rapport cyclique de l'interrupteur SW2 avec la valeur seuil DC_lim afin de détecter tout passage au-dessus de la valeur seuil DC_lim, afin de pouvoir, le cas échéant, arrêter la deuxième stratégie de pilotage et appliquer à nouveau la première stratégie de pilotage.

Dans le cas où la tension mesurée Vdc excède toujours la limite de tension Vlim, ou de façon équivalente lorsque la valeur déterminée du rapport cyclique de l'interrupteur SW2 est toujours inférieure à la valeur seuil DC_lim, alors la deuxième stratégie de commande reste en place.

En variante, les étapes pourraient être exécutées dans un ordre différent. Certaines étapes pourraient être omises. L'exemple décrit ne fait pas obstacle à ce que, dans d'autres modes de réalisation, d'autres étapes soient mises en oeuvre conjointement et/ou séquentiellement avec les étapes décrites.

Les modes de réalisation et les variantes envisagés ci-dessus peuvent être combinés entre eux pour créer de nouveaux modes de réalisation.

**Revendications**

1. Procédé de pilotage d'un actionneur électromagnétique, comportant une bobine (Bob), un circuit d'alimentation électrique pour alimenter la bobine, et un circuit de commande électronique, le circuit d'alimentation comportant un étage de commutation comprenant un pont en H comprenant plusieurs interrupteurs (SW1, SW2, SW3) connectés à la bobine, le premier interrupteur (SW1) étant connecté dans un premier bras du pont entre une masse électrique du circuit d'alimentation (GND) et la bobine, le deuxième interrupteur (SW2) étant connecté entre le bus de tension (Vdc) et la bobine dans un deuxième bras du pont en H, le troisième interrupteur (SW3) étant connecté entre la bobine et la masse électrique dans un troisième bras du pont, le procédé de pilotage étant **caractérisé en ce qu'**il comporte des étapes comprenant :

- appliquer (102) une première stratégie de pilotage dans laquelle les premier et troisième interrupteurs sont maintenus dans un état fermé, tandis que le deuxième interrupteur est commuté entre ses états ouvert et fermé ;
- détecter (104) un évènement de surconsommation de courant dans la bobine, en détectant que la tension mesurée sur le bus de commande (Vdc) excède une limite de tension prédéfinie (Vlim) ou en détectant que le rapport cyclique du deuxième interrupteur (SW2) devient inférieur à une valeur seuil (DC_lim) ;
- en réponse, appliquer (106) une deuxième stratégie de pilotage, à la place de la première stratégie de pilotage, dans laquelle le troisième interrupteur (SW3) est périodiquement ouvert afin de diminuer le courant alimentant la bobine.

2. Procédé de pilotage selon la revendication 1, dans lequel, lorsque la deuxième stratégie de pilotage est appliquée, la tension mesurée est à nouveau comparée avec la valeur de la limite de tension, pour détecter si la tension mesurée est repassée ou non sous la limite de tension, afin de pouvoir, le cas échéant, arrêter (108) la deuxième stratégie de pilotage et appliquer à nouveau la première stratégie de pilotage.

3. Procédé de pilotage selon l'une quelconque des revendications précédentes, dans lequel, dans la deuxième stratégie de pilotage, le rapport cyclique du signal de commande du deuxième interrupteur (SW2) est donné par la formule suivante :

$$aSW2 = ToffSW3 \times (Vdc - Vd) + T(Vd\text{-}Ri)/(Tx(Vdc+Vd))$$

où ToffSW3 est le temps pendant lequel le troisième interrupteur (SW3) reste ouvert pendant chaque période, Ri est égal au produit du courant circulant dans la bobine (Bob) par la résistance intrinsèque (R) de la bobine, Vd désigne la tension aux bornes d'une diode connectée entre un deuxième point du circuit et la première ligne conductrice du bus de tension, et T est la périodicité du signal de commande du deuxième interrupteur (SW2).

4. Procédé de pilotage selon l'une quelconque des revendications précédentes, dans lequel, dans la deuxième stratégie de pilotage, le rapport cyclique du signal de commande du troisième interrupteur (SW3) reste constant, ou peut varier au cours du temps.

5. Procédé de pilotage selon l'une quelconque des revendications précédentes, dans lequel les interrupteurs sont des transistors.

6. Procédé de pilotage selon l'une quelconque des revendications précédentes, dans lequel le courant circulant dans la bobine est mesurée au moyen d'un dispositif de mesure (20), de préférence associé au troisième interrupteur (SW3).

7. Actionneur électromagnétique, comportant une bobine, un circuit d'alimentation électrique pour alimenter la bobine, et un circuit de commande électronique, le circuit d'alimentation comportant un étage de commutation comprenant un pont en H comprenant plusieurs interrupteurs (SW1, SW2, SW3) connectés à la bobine, le premier interrupteur (SW1) étant connecté dans un premier bras du pont entre une masse électrique du circuit d'alimentation (GND) et la bobine, le deuxième interrupteur (SW2) étant connecté entre le bus de tension (Vdc) et la bobine dans un deuxième bras du pont en H, le troisième interrupteur (SW3) étant connecté entre la bobine et la masse électrique dans un troisième bras du pont,
l'actionneur électromagnétique étant **caractérisé en ce que** le circuit de commande électronique est programmé pour mettre en oeuvre des étapes comportant :

- appliquer (102) une première stratégie de pilotage dans laquelle les premier et troisième interrupteurs sont maintenus dans un état fermé, tandis que le deuxième interrupteur est commuté entre ses états ouvert et fermé ;
- détecter (104) un évènement de surconsommation de courant dans la bobine, en détectant que la tension mesurée sur le bus de commande (Vdc) excède une limite de tension prédéfinie (Vlim) ou en détectant que le rapport cyclique du deuxième interrupteur (SW2) devient inférieur à une valeur seuil (DC_lim) ;
- en réponse, appliquer (106) une deuxième stratégie de pilotage, à la place de la première stratégie de pilotage, dans laquelle le troisième interrupteur (SW3) est périodiquement ouvert afin de diminuer le courant alimentant la bobine.

**Patentansprüche**

1. Verfahren zum Ansteuern eines elektromagnetischen Aktuators, umfassend eine Spule (Bob), einen Stromversorgungskreislauf zum Versorgen der Spule und einen elektronischen Steuerschaltkreis, der Stromversorgungskreislauf umfassend eine Schaltstufe, die eine H-Brücke umfasst, umfassend mehrere Schalter (SW1, SW2, SW3), die mit der Spule verbunden sind, wobei der erste Schalter (SW1) in einem ersten Arm der Brücke zwischen einer elektrischen Masse des Versorgungskreislauf (GND) und der Spule verbunden ist, der zweite Schalter (SW2) zwischen dem Spannungsbus (Vdc) und der Spule in einem zweiten Arm der H-Brücke verbunden ist, der dritte Schalter (SW3) zwischen der Spule und der elektrischen Masse in einem dritten Arm der Brücke verbunden ist, wobei das Ansteuerungsverfahren **dadurch gekennzeichnet ist, dass** es Schritte umfasst, die Folgendes umfassen:

   - anwenden (102) einer ersten Ansteuerungsstrategie, bei der der erste und der dritte Schalter in einem geschlossenen Zustand gehalten werden, während der zweite Schalter zwischen seinen offenen und geschlossenen Zustand umgeschaltet wird;
   - erfassen (104) eines Überstromereignisses in der Spule, durch Erfassen, dass die auf dem Steuerbus gemessene Spannung (Vdc) eine vordefinierte Spannungsgrenze (Vlim) überschreitet, oder durch Erfassen, dass das Tastverhältnis des zweiten Schalters (SW2) unter einen Schwellenwert (DC_lim) fällt;
   - als Reaktion darauf, Anwenden (106) einer zweiten Ansteuerungsstrategie anstelle der ersten Ansteuerungsstrategie, bei der der dritte Schalter (SW3) periodisch geöffnet wird, um den Strom zu verringern, der der Spule zugeführt wird.

2. Ansteuerungsverfahren nach Anspruch 1, wobei bei Anwendung der zweiten Ansteuerungsstrategie die gemessene Spannung erneut mit dem Wert der Spannungsgrenze verglichen wird, um zu erfassen, ob die gemessene Spannung wieder unter die Spannungsgrenze gefallen ist, um gegebenenfalls die zweite Ansteuerungsstrategie stoppen (108) und die erste Ansteuerungsstrategie erneut anwenden zu können.

3. Ansteuerungsverfahren nach einem der vorherigen Ansprüche, wobei in der zweiten Ansteuerungsstrategie das Tastverhältnis des Steuersignals des zweiten Schalters (SW2) durch die folgende Formel gegeben ist:

$$aSW2 = ToffSW3 \times (Vdc - Vd) + T(Vd-Ri)/(Tx(Vdc+Vd)),$$

   wobei ToffSW3 die Zeit ist, während der der dritte Schalter (SW3) während jeder Periode geöffnet bleibt, Ri gleich wie das Produkt aus dem in der Spule (Bob) fließenden Strom und dem Eigenwiderstand (R) der Spule ist, Vd die Spannung über einer Diode bezeichnet, die zwischen einem zweiten Punkt der Schaltung und der ersten leitenden Leitung des Spannungsbusses angeschlossen ist, und T die Periodizität des Steuersignals des zweiten Schalters (SW2) ist.

4. Ansteuerungsverfahren nach einem der vorherigen Ansprüche, wobei in der zweiten Ansteuerungsstrategie das Tastverhältnis des Steuersignals für den dritten Schalter (SW3) konstant bleibt oder sich im Lauf der Zeit ändern kann.

5. Ansteuerungsverfahren nach einem der vorherigen Ansprüche, wobei die Schalter Transistoren sind.

6. Ansteuerungsverfahren nach einem der vorherigen Ansprüche, wobei der in der Spule fließende Strom mittels einer Messvorrichtung (20) gemessen wird, die vorzugsweise mit dem dritten Schalter (SW3) assoziiert ist.

7. Elektromagnetischer Aktuator, umfassend eine Spule, einen Stromversorgungskreislauf zum Versorgen der Spule und einen elektronischen Steuerschaltkreis, der Stromversorgungskreislauf umfassend eine Schaltstufe, die eine H-Brücke umfasst, umfassend mehrere Schalter (SW1, SW2, SW3), die mit der Spule verbunden sind, wobei der erste Schalter (SW1) in einem ersten Arm der Brücke zwischen einer elektrischen Masse des Versorgungskreislauf (GND) und der Spule verbunden ist, der zweite Schalter (SW2) zwischen dem Spannungsbus (Vdc) und der Spule in einem zweiten Arm der H-Brücke verbunden ist, der dritte Schalter (SW3) zwischen der Spule und der elektrischen Masse in einem dritten Arm der Brücke verbunden ist, wobei der elektromagnetische Aktuator **dadurch gekennzeichnet ist, dass** die elektronische Steuerschaltung programmiert ist, um Schritte auszuführen, die Folgendes umfassen:

   - anwenden (102) einer ersten Ansteuerungsstrategie, bei der der erste und der dritte Schalter in einem geschlossenen Zustand gehalten werden, während der zweite Schalter zwischen seinen offenen und geschlossenen Zustand umgeschaltet wird;
- erfassen (104) eines Überstromereignisses in der Spule durch Erfassen, dass die auf dem Steuerbus gemessene Spannung (Vdc) eine vordefinierte Spannungsgrenze (Vlim) überschreitet, oder durch Erfassen, dass das Tastverhältnis des zweiten Schalters (SW2) unter einen Schwellenwert (DC_lim) fällt;
- als Reaktion darauf, Anwenden (106) einer zweiten Ansteuerungsstrategie anstelle der ersten Ansteuerungsstrategie, bei der der dritte Schalter (SW3) periodisch geöffnet wird, um den Strom zu verringern, der der Spule zugeführt wird.

## Claims

1. A method of driving an electromagnetic actuator, comprising a coil (Bob), an electrical supply circuit for supplying power to the coil, and an electronic control circuit, the supply circuit comprising a switching stage comprising an H-bridge comprising a plurality of switches (SW1, SW2, SW3) connected to the coil, the first switch (SW1) being connected in a first arm of the bridge between an electrical earth (GND) and the coil, and the second switch (SW2) being connected between the voltage bus (Vdc) and the coil in a second arm of the H-bridge, the third switch (SW3) being connected between the coil and electrical earth in a third arm of the bridge, the driving method being **characterised in that** it includes steps comprising :

   - apply (102) a first control strategy in which the first and third switches are held in a closed state, while the second switch is switched between its open and closed states;
   - detecting (104) an overcurrent event in the coil, by detecting that the voltage measured on the control bus (Vdc) exceeds a predefined voltage limit (Vlim) or by detecting that the duty cycle of the second switch (SW2) becomes lower than a threshold value (DC_lim);
   - in response, apply (106) a second driving strategy, instead of the first driving strategy, in which the third switch (SW3) is periodically opened to decrease the current to the coil.

2. The control method according to claim 1, wherein, when the second control strategy is applied, the measured voltage is compared again with the value of the voltage limit, in order to determine whether or not the measured voltage has fallen below the voltage limit, so that the second control strategy can be stopped (108) and apply the first control strategy again if necessary.

3. A control method according to any of the preceding claims, wherein in the second control strategy, the duty cycle of the control signal of the second switch (SW2) is given by the following formula:

$$aSW2 = ToffSW3 \times (Vdc - Vd) + T(Vd\text{-}Ri)/(Tx(Vdc\text{+}Vd))$$

   where ToffSW3 is the time the third switch (SW3) remains open during each period, Ri is equal to the product of the current flowing in the coil (Bob) and the intrinsic resistance (R) of the coil, Vd is the voltage across a diode connected between a second point in the circuit and the first conducting line of the voltage bus, and T is the periodicity of the control signal of the second switch (SW2).

4. A driving method according to any one of the preceding claims, wherein in the second driving strategy the duty cycle of the control signal of the third switch (SW3) remains constant, or may vary over time.

5. A driving method according to any of the preceding claims, wherein the switches are transistors.

6. A driving method according to any of the preceding claims, wherein the current flowing in the coil is measured by means of a measuring device (20), preferably associated with the third switch (SW3).

7. An electromagnetic actuator, comprising a coil, an electrical supply circuit for supplying power to the coil, and an electronic control circuit, the supply circuit comprising a switching stage including an H-bridge comprising a plurality of switches (SW1, SW2, SW3) connected to the coil, the first switch (SW1) being connected in a first arm of the bridge between an electrical supply circuit ground (GND) and the coil, the second switch (SW2) being connected between the voltage bus (Vdc) and the coil in a second arm of the H-bridge, the third switch (SW3) being connected between the coil and electrical ground in a third arm of the bridge, the electromagnetic actuator being **characterised in that** the electronic control circuit is programmed to implement steps comprising:

- applying (102) a first control strategy in which the first and third switches are held in a closed state, while the second switch is switched between its open and closed states;
- detecting (104) an overcurrent event in the coil, by detecting that the voltage measured on the control bus (Vdc) exceeds a predefined voltage limit (Vlim) or by detecting that the duty cycle of the second switch (SW2) becomes lower than a threshold value (DC_lim);
- in response, applying (106) a second driving strategy, instead of the first driving strategy, in which the third switch (SW3) is periodically opened to decrease the current to the coil.

FIG.1

## FIG.2

FIG.3

FIG.4

**EP 4 036 950 B1**

## RÉFÉRENCES CITÉES DANS LA DESCRIPTION

### Documents brevets cités dans la description

- EP 3185272 A1